# EUROPEAN PATENT APPLICATION

(11) **EP 4 749 624 A1**
(43) Date of publication of application: **27.05.2026**
(21) Application number: 25214738.4
(22) Date of filing: 10.11.2025
(51) Int. Cl.: G11C 7/18, H10B 12/00, G11C 5/02

(54) **MEMORY DEVICE AND MANUFACTURING METHOD THEREOF**

(30) Priority: 20.11.2024 KR 20240165843
(71) Applicant: SK hynix Inc., Bubal-eub Icheon-si Gyeonggi-do 17336 (KR)
(72) Inventor: KIM, Jun Sik, 17336 Icheon-si, Gyeonggi-do (KR)
(74) Representative: Isarpatent

(57) **Abstract**

A memory device including a first substrate including a cell region and a peripheral region disposed around the cell region; a memory cell array disposed in the cell region of the first substrate; a second substrate disposed on the memory cell array; peripheral transistors disposed on the second substrate and connected to the memory cell array; a first insulating layer disposed in a trench that is located in the peripheral region of the first substrate, and including high density plasma oxide; and a second insulating layer on the first insulating layer.

## Description

### BACKGROUND

### 1. Technical Field

Embodiments of the present disclosure relate generally to semiconductor technology and, in particular, to a memory device and a method for manufacturing the same.

### 2. Related Art

Memory devices are attracting attention as an important element in the electronics industry due to their characteristics such as miniaturization, multifunctionality generally low manufacturing cost. As the electronics industry has developed rapidly, memory devices are becoming increasingly more highly integrated. Higher integration requires decreasing the line width of wirings and/or the size of memory cells included in the memory devices. However, this has become increasingly more difficult and new structures, materials, and techniques are needed for further improvements to be made.

One such method allowing higher integration of memory devices includes a process of fabricating memory devices by separately fabricating a wafer in which memory cells may be disposed and a wafer in which peripheral circuits may be disposed and then bonding the two wafers together. However, fabricating memory devices using wafer bonding, requires more efficiently disposing the various components and circuits in the memory devices.

### SUMMARY

Various embodiments of the present disclosure are directed to providing a memory device that includes bonding two semiconductor structures together in a way that is capable of preventing degradation of memory cells and a method for manufacturing the same. In an embodiment of the present disclosure, a memory device may include a first substrate including a cell region and a peripheral region disposed around the cell region; a memory cell array disposed in the cell region of the first substrate; a second substrate disposed on the memory cell array; peripheral transistors disposed on the second substrate and connected to the memory cell array; a first insulating layer disposed in a trench that is located in the peripheral region of the first substrate, and including high density plasma oxide; and a second insulating layer on the first insulating layer.

In an embodiment of the present disclosure, a memory device may include a first substrate; a memory cell array disposed on the first substrate; a first insulating layer disposed in a trench located in the first substrate, surrounding a region where the memory cell array is disposed, and including high density plasma oxide; and a second insulating layer covering the upper surface of the first insulating layer.

In an embodiment of the present disclosure, a memory device including a first semiconductor structure and a second semiconductor structure bonded onto the first semiconductor structure is provided, wherein the first semiconductor structure includes a first substrate including a cell region and a peripheral region around the cell region; a memory cell array disposed in the cell region of the first substrate; a first insulating layer disposed in the peripheral region of the first substrate; and a second insulating layer covering the upper surface of the first insulating layer, wherein the second semiconductor structure includes a second substrate; and peripheral transistors disposed on the second substrate, and connected to the memory cell array, and wherein at least one of the peripheral transistors overlaps with the cell region.

In an embodiment of the present disclosure, a method for manufacturing a memory device including a first semiconductor structure including a memory cell array and a second semiconductor structure including peripheral transistors may include forming a trench in a peripheral region of a first substrate including a cell region and the peripheral region around the cell region; forming a first insulating layer including high density plasma oxide in the trench; forming the memory cell array in the cell region of the first substrate; and forming the peripheral transistors on the memory cell array to be connected to the memory cell array.

According to an embodiment of the present disclosure, degradation of memory cells may be prevented.

### BRIEF DESCRIPTION OF THE DRAWINGS

FIG. 1 is a block diagram illustrating a memory device according to embodiments of the present disclosure.
FIG. 2 is a diagram illustrating a circuit configuration of the memory device according to an embodiment of the present disclosure.
FIG. 3 is a view illustrating a planar structure of the memory device according to an embodiment of the present disclosure.
FIG. 4 is a view illustrating an example of the cross-sectional structure of the memory device according to an embodiment of the present disclosure.
FIG. 5 is a view illustrating the memory device illustrated in FIG. 4.
FIG. 6 is a view illustrating another cross-sectional structure of the memory device according to an embodiment of the present disclosure.
FIG. 7 is a view illustrating the memory device illustrated in FIG. 6.
FIG. 8 and FIG. 9 are views illustrating other embodiments of the memory device illustrated in FIG. 6.
FIG. 10 is a view illustrating still another cross-sectional structure of the memory device according to an embodiment of the present disclosure.
FIG. 11 is a view illustrating an embodiment of the memory device illustrated in FIG. 10.

### DETAILED DESCRIPTION

Embodiments of the present disclosure are described in detail with reference to the accompanying drawings. Specific structural or functional descriptions of embodiments are provided as examples to describe the technical concepts that are disclosed in the present disclosure. Embodiments in accordance with the technical concepts may be carried out in various forms, and the scope of the present disclosure is not limited to the embodiments described in this specification.

The cross-hatching throughout the figures illustrates corresponding or similar areas between the figures rather than indicating the materials associated with the areas.

When one element is identified as "connected" or "coupled" to another element, the elements may be connected or coupled directly or through an intervening element between the elements. When two elements are identified as "directly connected" or "directly coupled," one element is directly connected or directly coupled to the other element without an intervening element between the two elements.

When one element is identified as "on," "over," "under," or "beneath" another element, the elements may directly contact each other or an intervening element may be disposed between the elements.

Terms such as "vertical," "horizontal," "top," "bottom," "above," "below," "under," "beneath," "over," "on," "side," "upper," "uppermost," "lower," "lowermost," "front," "rear," "left," "right," "column," "row," "level," and other terms implying relative spatial relationship or orientation are utilized only for the purpose of ease of description or reference to a drawing and are not otherwise limiting. Other spatial relationships or orientations not shown in the drawings or described in the specification are possible within the scope of the present disclosure.

Terms such as "first" and "second" are used to distinguish between various elements and do not imply size, order, priority, quantity, or importance of the elements. For example, a first element may be named as a second element in one embodiment, and the second element may be named as a first element in another embodiment.

In the description, when an element included in an embodiment is described in singular form, the element may be interpreted to include a plurality of elements performing the same or similar functions.

In the accompanying drawings, three directions that are parallel to the upper surface of a substrate are defined as a first direction FD, a second direction SD and a third direction TD, respectively, and a direction that vertically protrudes from the upper surface of the substrate is defined as a fourth direction VD. The first direction FD and the second direction SD may be substantially perpendicular to each other. The fourth direction VD is a direction that is perpendicular to the first direction FD, the second direction SD and the third direction TD. In the following description, the term 'vertical' or 'vertical direction' will be used as having substantially the same meaning as the fourth direction VD. In the drawings, a direction indicated by an arrow and a direction opposite thereto represent the same direction.

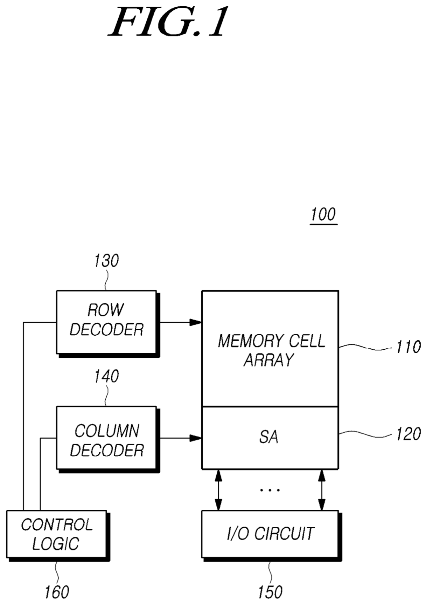

FIG. 1 is a block diagram illustrating a memory device according to embodiments of the present disclosure.

A memory device 100 may include a memory cell array 110, a sense amplifier 120, a row decoder 130, a column decoder 140, an input/output circuit 150, and a control logic 160.

The memory cell array 110 includes a plurality of memory cells that may serve, for example, for storing data.

The sense amplifier 120 is connected to the plurality of memory cells included in the memory cell array 110. In operation, the sense amplifier 120 may detect (sense) and amplify a signal (e.g., small voltage changes) when reading data stored in memory cells or when writing data into memory cells. For example, when writing data, i.e., in a write operation, the sense amplifier 120 may amplify a signal received from the input/output circuit 150 and provide the amplified signal to memory cells in the memory cell array 110 ensuring the data is accurately written and stored. In a read operation, when reading data, the sense amplifier 120 may sense data stored in memory cells, amplify a signal for sensed data and provide the amplified signal to the input/output circuit 150.

The row decoder 130 may select a corresponding word line in the memory cell array 110 according to a designated row address. The row decoder 130 may generate a word line drive signal for driving a selected word line.

The column decoder 140 may decode a column address to activate a column select signal and select a plurality of bit lines according to one column select signal.

When a write operation is executed, the input/output circuit 150 may write input data to memory cells. When a read operation is executed, the input/output circuit 150 may sense, amplify and output data loaded on input/output lines.

The control logic 160 may control peripheral circuits of the memory device 100, including the row decoder 130 and the column decoder 140, according to a received command.

The components 110, 120, 130, 140, 150 and 160 of the memory device 100 described above with reference to FIG. 1 illustrate just one example of a possible configuration of a memory device. Many variations thereof may be implemented, including embodiments wherein one or more of the components described above may be omitted. Alternatively, in some embodiments of the memory device, one or more of the components described above may be integrated with another component. As the case may be, in addition to the components described above, at least one component may be included in the memory device 100.

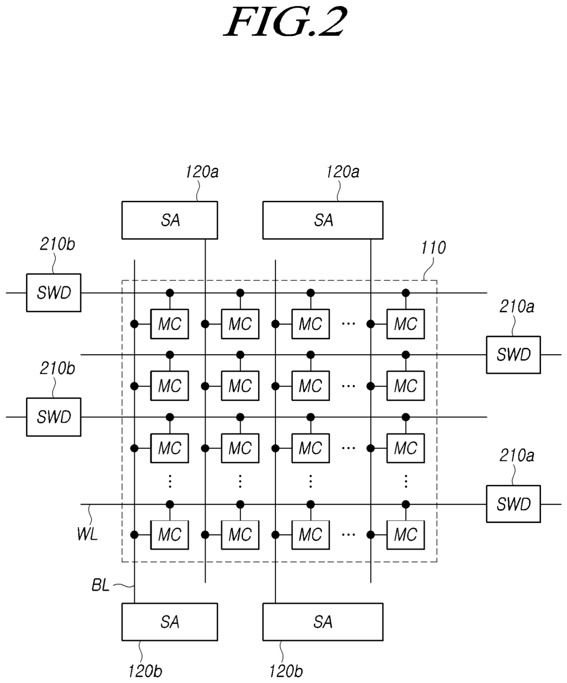

FIG. 2 is a diagram illustrating a circuit configuration of the memory device according to an embodiment of the present disclosure.

Referring to FIG. 2, the memory device 100 may include the memory cell array 110, word lines WL, bit lines BL, memory cells MC, first sense amplifiers 120a, second sense amplifiers 120b, first sub word line drivers 210a and second sub word line drivers 210b.

Each of the bit lines BL and the word lines WL is connected to a plurality of memory cells MC in the memory cell array 110. The bit lines BL and the word lines WL intersect each other. The memory cells MC may be disposed at points where the bit lines BL and the word lines WL intersect each other. The bit lines BL and the word lines WL intersect at each memory cell MC, creating a grid-like structure.

A bit line BL may be connected to a first sense amplifier 120a or to a second sense amplifier 120b. Two adjacent bit lines BL may be connected to a first sense amplifier 120a and a second sense amplifier 120b, respectively. For example, bit lines BL connected to the first sense amplifiers 120a may be disposed between bit lines BL connected to the second sense amplifiers 120b. A bit line BL connected to a first sense amplifier 120a may be adjacent to a bit line BL connected to a second sense amplifier 120b.

The word lines WL may be connected to a first sub word line driver 210a or to a second sub word line driver 210b. Each of the first sub word line drivers 210a and the second sub word line drivers 210b may receive a signal required for driving a word line WL from the row decoder 130 illustrated in FIG. 1, and may drive a word line WL selected among the word lines WL. Two adjacent word lines WL may be connected to a first sub word line driver 210a and a second sub word line driver 210b, respectively. For example, word lines WL connected to the first sub word line drivers 210a may be disposed between word lines WL connected to the second sub word line drivers 210b. A word line WL connected to a first sub word line driver 210a may be adjacent to a word line WL connected to a second sub word line driver 210b.

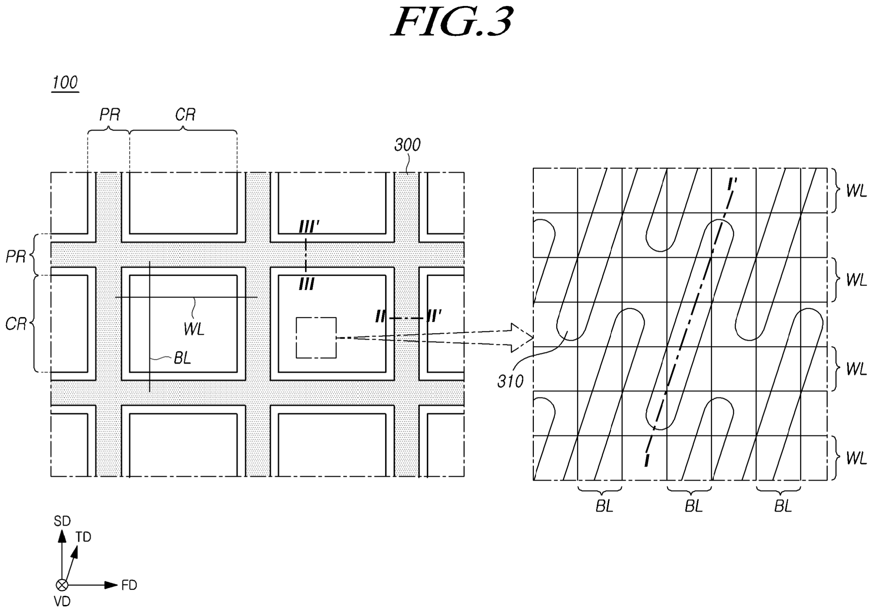

FIG. 3 is a view illustrating a planar structure of the memory device according to an embodiment of the present disclosure.

Referring to FIG. 3, the memory device 100 may include a cell region CR and a peripheral region PR. The cell region CR is a region where the memory cell array 110 illustrated in FIG. 1 and FIG. 2 is disposed. The peripheral region PR is a region where peripheral circuits for transmitting various voltages or signals to the memory cells disposed in the cell region CR are disposed. The peripheral region PR is disposed around the cell region CR. In an embodiment, the peripheral region PR may surround the cell region CR.

The memory device 100 may include bit lines BL, word lines WL and active regions 310.

The active regions 310 may be spaced apart from each other in the first direction FD and the second direction SD. The active regions 310 may extend in the third direction TD. The bit lines BL and the word lines WL may be disposed to cross the active regions 310. The bit lines BL extend in the second direction SD. The word lines WL extend in the first direction FD. The bit lines BL and the word lines WL may be disposed to overlap with the cell region CR. In an embodiment, at least some of the bit lines BL may extend to the peripheral region PR in the second direction SD. In an embodiment, at least some of the word lines WL may extend to the peripheral region PR in the first direction FD.

FIG. 3 illustrates one bit line BL and one word line WL that may be disposed in one cell region CR, but this is for the sake of convenience in description. For example, the number of bit lines BL and the number of word lines WL disposed in the cell region CR may be greater than one. The bit lines BL and the word lines WL may be disposed in all cell regions CR.

A first insulating layer 300 may be disposed in the peripheral region PR. The first insulating layer 300 may be disposed between adjacent cell regions CR. In an embodiment, the first insulating layer 300 may surround the cell region CR.

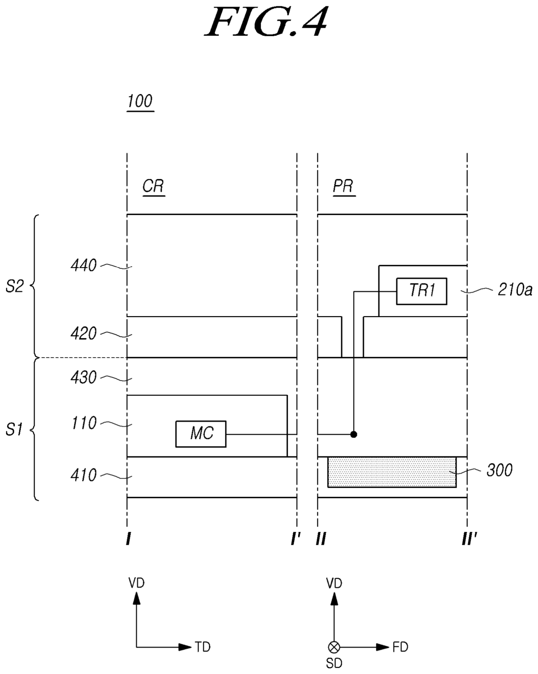

FIG. 4 is a view illustrating a cross-sectional structure of the memory device according to an embodiment of the present disclosure.

Referring to FIG. 4, the memory device 100 may include a first semiconductor structure S1 and a second semiconductor structure S2 disposed on the first semiconductor structure. The first semiconductor structure S1 and the second semiconductor structure S2 may be fabricated on different wafers. In an embodiment, a process of fabricating the first semiconductor structure S1 may be performed separately from a process of fabricating the second semiconductor structure S2. The second semiconductor structure S2 may be bonded to the upper surface of the first semiconductor structure S1. The boundary between the first semiconductor structure S1 and the second semiconductor structure S2 may be referred to as a bonding interface.

The first semiconductor structure S1 may include a first substrate 410, a memory cell array 110, a memory cell MC, a first insulating layer 300 and a first interlayer insulating layer 430.

In a cell region CR, the memory cell array 110 which includes the memory cells MC may be disposed on the first substrate 410. In a peripheral region PR, the first insulating layer 300 is disposed in the first substrate 410. In an embodiment, the first insulating layer 300 may surround a region where the memory cell array 110 is disposed. The first interlayer insulating layer 430 is disposed on the memory cell array 110.

The second semiconductor structure S2 is disposed on the first semiconductor structure S1. The second semiconductor structure S2 may include a second substrate 420, a first sub word line driver 210a and a second interlayer insulating layer 440.

The first sub word line driver 210a may be disposed on the second substrate 420. In an embodiment, the first sub word line driver 210a may be disposed in the peripheral region PR. The first sub word line driver 210a may include a first peripheral transistor TR1. The first peripheral transistor TR1 may constitute the first sub word line driver 210a. The second interlayer insulating layer 440 may be disposed on the second substrate 420 and the first sub word line driver 210a. Although it is illustrated that the first sub word line driver 210a may be disposed on the second substrate 420, this is only provided as an example. That is, a second sub word line driver 210b (see FIG. 2) may be disposed on the second substrate 420.

The memory cell MC may be electrically connected to the first peripheral transistor TR1. For example, one memory cell MC may be connected to one word line WL, and may be electrically connected to the first peripheral transistor TR1 through the one word line WL.

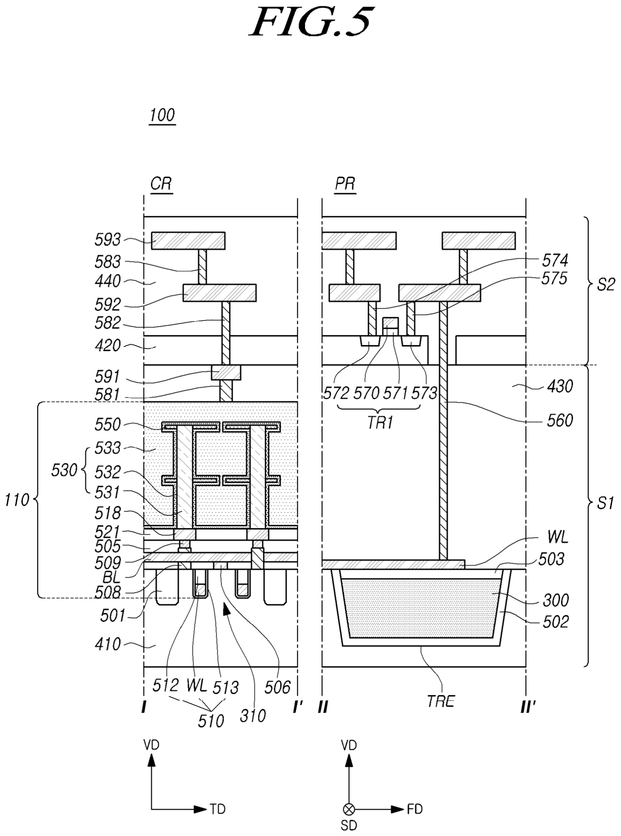

FIG. 5 is a detailed view illustrating the memory device illustrated in FIG. 4.

Referring to FIG. 5, the memory device 100 may include a first semiconductor structure S1, a second semiconductor structure S2 disposed on the first semiconductor structure S1, and a word line connection contact 560 extending both inside the first and second semiconductor structures S1 and S2. The first semiconductor structure S1 may include a first substrate 410, an isolation layer 501, a gate structure 510, a third insulating layer 505, a bit line contact 506, a bit line BL, a lower contact plug 508, an upper contact plug 509, a landing pad 518, a capacitor 530, a support layer 550, a fourth insulating layer 521, a first contact 581, a first wiring 591, a liner insulating layer 502, a first insulating layer 300, a second insulating layer 503, and a first interlayer insulating layer 430.

The first substrate 410 may include a semiconductor substrate such as a silicon wafer or an SOI (silicon on insulator) wafer. The first substrate 410 may include a III-V group semiconductor substrate, for example, a compound semiconductor substrate such as gallium arsenide (GaAs). The first substrate 410 may include monocrystalline silicon, polysilicon, amorphous silicon, monocrystalline silicon germanium, polycrystalline silicon germanium, carbon-doped silicon or a combination thereof.

The first substrate 410 may include at least one isolation layer 501 in a cell region CR and a peripheral region PR. The isolation layer 501 may be formed using a trench isolation technology such as shallow trench isolation (STI). The isolation layer 501 may include silicon oxide, silicon nitride, silicon oxynitride, low-k dielectric, high-k dielectric or a combination thereof.

In the cell region CR, the gate structure 510 may be buried in the first substrate 410. The gate structure 510 may include a word line WL, a gate capping layer 512, and a gate insulating layer 513. The upper surface of the word line WL may be located at a level lower than the upper surface of the first substrate 410. The word line WL may be a buried gate or a buried word line. The gate capping layer 512 may be disposed on the word line WL. The gate insulating layer 513 may surround the side surfaces of the word line WL and the gate capping layer 512, and the bottom surface of the word line WL.

The word line WL may include a conductive material such as metal, metal oxide, metal nitride, metal silicide, polysilicon, conductive carbon or a combination thereof. The gate capping layer 512 may include silicon oxide, silicon nitride, silicon oxynitride, low-k dielectric, high-k dielectric or a combination thereof. The gate insulating layer 513 may include silicon oxide, silicon nitride, silicon oxynitride, high-k dielectric or a combination thereof.

The third insulating layer 505, the bit line contact 506 and the contact plugs 508 and 509 may be disposed on the first substrate 410.

In the cell region CR, the bit line BL may be disposed on the bit line contact 506. The bit line BL may extend in a direction perpendicular to the word line WL. The bit line BL might not contact the contact plugs 508 and 509. An insulating layer may be additionally disposed between the bit line BL and the contact plugs 508 and 509. The landing pad 518 and the fourth insulating layer 521 may be disposed on the upper contact plug 509. The landing pad 518 may overlap with the upper contact plug 509 in the vertical direction VD.

The bit line contact 506, the bit line BL, the contact plugs 508 and 509 and the landing pad 518 may include a conductive material such as metal, metal oxide, metal nitride, metal silicide, polysilicon, conductive carbon or a combination thereof.

A lower electrode 531, a dielectric layer 532, an upper electrode 533 and the support layer 550 may be disposed on the fourth insulating layer 521 and the landing pad 518. The lower electrode 531, the dielectric layer 532 and the upper electrode 533 may constitute the capacitor 530 of a memory cell.

The lower electrode 531 may overlap with the landing pad 518 in the vertical direction VD. The support layer 550 may be disposed on the side surface of the lower electrode 531. The support layer 550 surrounds the side surface of the lower electrode 531. The support layer 550 disposed on the side surface of one lower electrode 531 may be separated from the support layer 550 disposed on the side surface of another lower electrode 531.

The dielectric layer 532 may be disposed to cover the surfaces of the lower electrode 531 and the support layer 550. The upper electrode 533 may be disposed on the dielectric layer 532. The upper surface of the upper electrode 533 may be located at a level higher than the upper surface of the lower electrode 531.

The lower electrode 531 and the upper electrode 533 may include a conductive material such as metal, metal oxide, metal nitride, metal silicide, polysilicon, conductive carbon or a combination thereof. The support layer 550 may include silicon nitride or silicon carbon nitride, but is not limited thereto. The dielectric layer 532 may include high-k dielectric, silicon oxide, silicon nitride or a combination thereof.

The first interlayer insulating layer 430 may be disposed on the upper electrode 533. The first contact 581 may pass through the first interlayer insulating layer 430 and may be connected to the upper electrode 533. The first wiring 591 may be disposed on the first contact 581.

In the peripheral region PR, the first substrate 410 includes at least one trench TRE. The liner insulating layer 502, the first insulating layer 300 and the second insulating layer 503 may be disposed in the trench TRE. In an embodiment, the liner insulating layer 502, the first insulating layer 300 and the second insulating layer 503 may surround a region where a memory cell array 110 is disposed. The liner insulating layer 502 may be disposed on the side surface and the bottom surface of the trench TRE. The liner insulating layer 502 may include oxide.

The first insulating layer 300 may be disposed on the liner insulating layer 502. The first insulating layer 300 may fill the interior of the trench TRE. The first insulating layer 300 may include hydrogen. The first insulating layer 300 may be a layer that has higher hydrogen supply capacity than other layers. The first insulating layer 300 may include oxide that has a high hydrogen content. In an embodiment, the first insulating layer 300 may include high a density plasma (HDP) oxide.

The second insulating layer 503 may be disposed on the first insulating layer 300. The second insulating layer 503 may cover the entire upper surface of the first insulating layer 300. In an embodiment, the upper surface of the second insulating layer 503 may form substantially the same plane as the upper surface of the first substrate 410. In an embodiment, the second insulating layer 503 may include silicon nitride.

A word line WL may be disposed on the second insulating layer 503. In an embodiment, the word line WL may be located on the upper surface of the first substrate 410 in at least a partial region of the peripheral region PR. Additionally, in an embodiment, the word line WL may extend into the peripheral region PR in the first direction FD. Furthermore, in an embodiment, the word line WL may overlap with the first insulating layer 300.

The word line connection contact 560 and the first interlayer insulating layer 430 may be disposed on the word line WL. The word line connection contact 560 penetrates the first interlayer insulating layer 430 and is connected to the word line WL. The word line connection contact 560 contacts the upper surface of the word line WL and extends in the vertical direction VD. The word line connection contact 560 may include a conductive material such as metal, metal oxide, metal nitride, metal silicide, polysilicon, conductive carbon or a combination thereof.

The second semiconductor structure S2 may be disposed on the first semiconductor structure S1. The second semiconductor structure S2 may include a second substrate 420, a second interlayer insulating layer 440, a second contact 582, a third contact 583, a second wiring 592, a third wiring 593, a first peripheral transistor TR1, and source and drain contacts 574 and 575.

The second substrate 420 may be disposed on the first semiconductor structure S1. In an embodiment, the second substrate 420 may include a material the same as a material that forms the first substrate 410.

In the cell region CR, the second contact 582 that penetrates the second substrate 420 is disposed. The second contact 582 penetrates the second substrate 420 in the vertical direction VD and contacts the upper surface of the first wiring 591.

The second wiring 592 is connected to the second contact 582. The third contact 583 may be disposed on the second wiring 592. The third wiring 593 is connected to the third contact 583. The second interlayer insulating layer 440 that covers the second contact 582, the second wiring 592, the third contact 583 and the third wiring 593 may be disposed on the second substrate 420.

In the peripheral region PR, the word line connection contact 560 penetrates the second substrate 420. The word line connection contact 560 penetrates the second substrate 420 and contacts the lower surface of the second wiring 592.

The first peripheral transistor TR1 may be disposed on the second substrate 420. The first peripheral transistor TR1 includes a gate electrode 570, a gate insulating layer 571, a source region 572 and a drain region 573. The first peripheral transistor TR1 is a transistor that is included in the first sub word line driver 210a illustrated in FIG. 4. In an embodiment, the first peripheral transistor TR1 may be disposed in the peripheral region PR.

The source contact 574 is connected to the source region 572 and the second wiring 592. The drain contact 575 is connected to the drain region 573 and the second wiring 592.

The first peripheral transistor TR1 may be connected to one word line WL through the drain contact 575 connected to the drain region 573, the second wiring 592 connected to the drain contact 575 and the word line connection contact 560 connected to the second wiring 592.

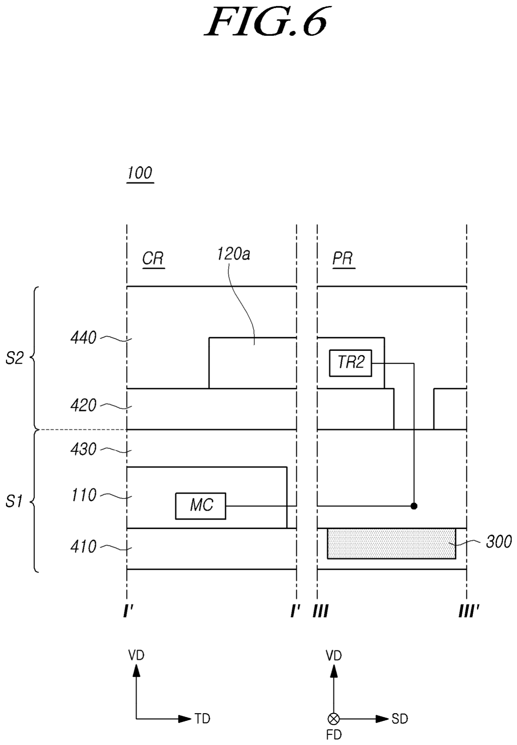

FIG. 6 is a view illustrating another cross-sectional structure of the memory device according to an embodiment of the present disclosure.

Referring to FIG. 6, the memory device 100 may include a first semiconductor structure S1 and a second semiconductor structure S2 disposed on the first semiconductor structure. The first semiconductor structure S1 may include a first substrate 410, a memory cell array 110, a memory cell MC, a first insulating layer 300 and a first interlayer insulating layer 430. The second semiconductor structure S2 may be disposed on the first semiconductor structure S1. The second semiconductor structure S2 may include a second substrate 420, a first sense amplifier 120a and a second interlayer insulating layer 440.

The first sense amplifier 120a may be disposed on the second substrate 420. The first sense amplifier 120a may be disposed in a cell region CR and a peripheral region PR. In an embodiment, the first sense amplifier 120a may overlap the cell region CR. The first sense amplifier 120a includes a second peripheral transistor TR2. The second peripheral transistor TR2 is one transistor that constitutes the first sense amplifier 120a. In an embodiment, the second peripheral transistor TR2 may be disposed in the peripheral region PR. The second interlayer insulating layer 440 may be disposed on the second substrate 420 and the first sense amplifier 120a. Although it is illustrated that the first sense amplifier 120a may be disposed on the second substrate 420, this is an example. That is, a second sense amplifier 120b (see FIG. 2) may be disposed on the second substrate 420.

The memory cell MC may be electrically connected to the second peripheral transistor TR2. For example, one memory cell MC may be connected to one bit line BL, and may be electrically connected to the second peripheral transistor TR2 through the one bit line BL.

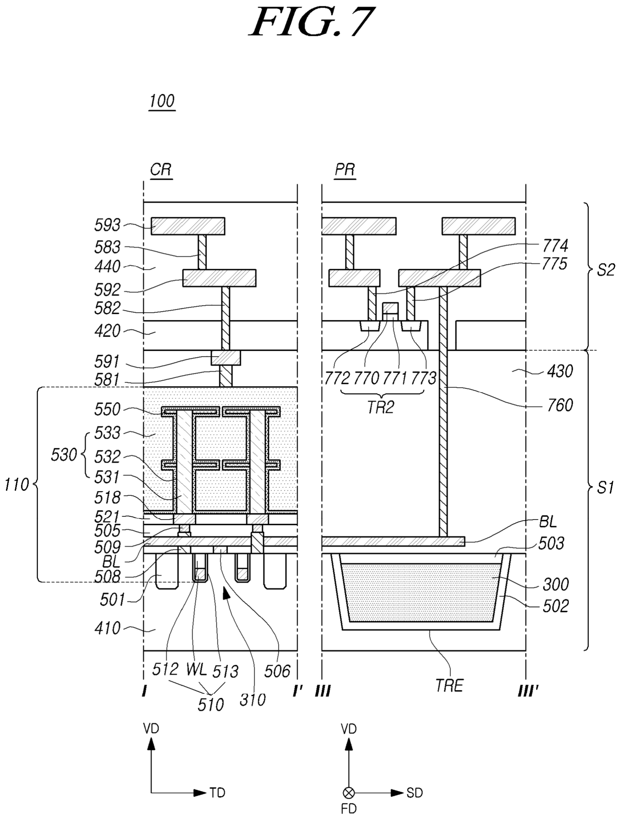

FIG. 7 is a view illustrating the memory device illustrated in FIG. 6.

Referring to FIG. 7, the memory device 100 may include a first semiconductor structure S1, a second semiconductor structure S2, and a bit line connection contact 760.

The first semiconductor structure S1 may include a first substrate 410, an isolation layer 501, a gate structure 510, a third insulating layer 505, a bit line contact 506, a bit line BL, a lower contact plug 508, an upper contact plug 509, a landing pad 518, a capacitor 530, a support layer 550, a fourth insulating layer 521, a first contact 581, a first wiring 591, a liner insulating layer 502, a first insulating layer 300, a second insulating layer 503, and a first interlayer insulating layer 430.

In a peripheral region PR, a bit line BL may be disposed on the second insulating layer 503. The bit line BL may be located at the same height as the bit line BL located in a cell region CR. The bit line BL may be spaced apart from the upper surface of the first substrate 410 in the vertical direction VD. In an embodiment, the bit line BL may extend to the peripheral region PR in the second direction SD. In an embodiment, the bit line BL may overlap the first insulating layer 300.

The bit line connection contact 760 and the first interlayer insulating layer 430 may be disposed on the bit line BL. The bit line connection contact 760 penetrates the first interlayer insulating layer 430 and is connected to the bit line BL. The bit line connection contact 760 contacts the upper surface of the bit line BL and extends in the vertical direction VD. The bit line connection contact 760 may include a conductive material such as metal, metal oxide, metal nitride, metal silicide, polysilicon, conductive carbon or a combination thereof.

The second semiconductor structure S2 may be disposed on the first semiconductor structure S1. The second semiconductor structure S2 may include a second substrate 420, a second interlayer insulating layer 440, a second contact 582, a third contact 583, a second wiring 592, a third wiring 593, a second peripheral transistor TR2, and source and drain contacts 774 and 775.

The second peripheral transistor TR2 may be disposed on the second substrate 420. The second peripheral transistor TR2 includes a gate electrode 770, a gate insulating layer 771, a source region 772 and a drain region 773. The second peripheral transistor TR2 is a transistor that is included in the first sense amplifier 120a illustrated in FIG. 6. In an embodiment, the second peripheral transistor TR2 may be disposed in the peripheral region PR.

The source contact 774 is connected to the source region 772 and the second wiring 592. The drain contact 775 is connected to the drain region 773 and the second wiring 592.

The second peripheral transistor TR2 may be connected to one bit line BL through the drain contact 775 connected to the drain region 773, the second wiring 592 connected to the drain contact 775 and the bit line connection contact 760 connected to the second wiring 592.

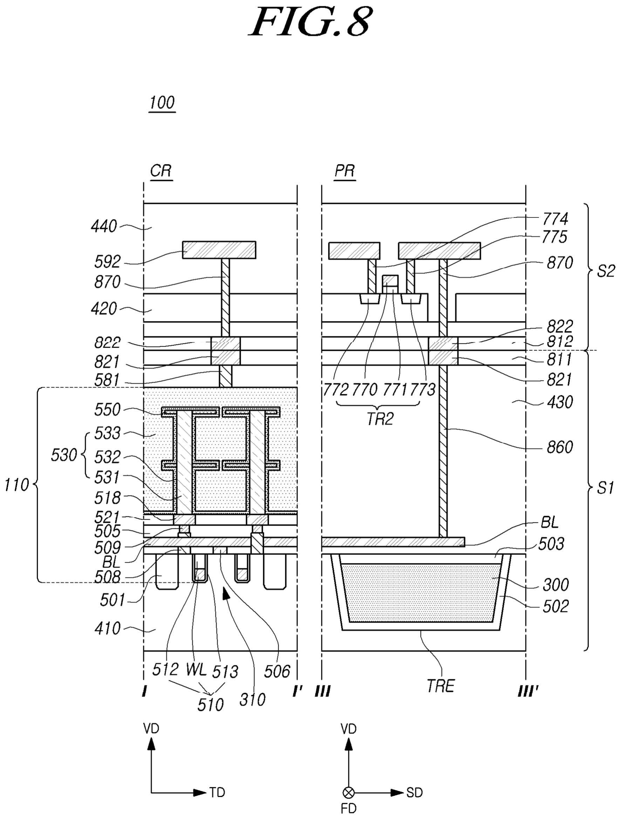

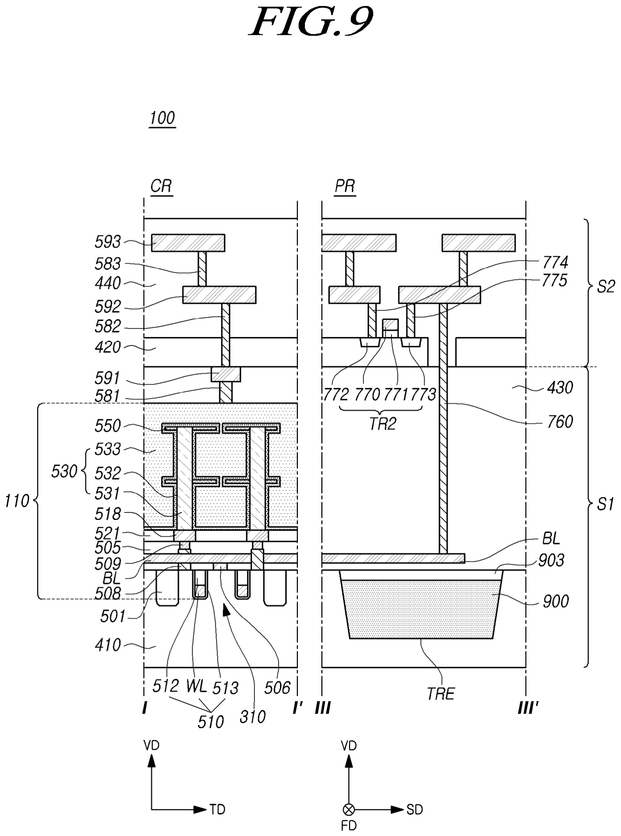

FIG. 8 and FIG. 9 are views illustrating other embodiments of the memory device illustrated in FIG. 6.

Referring to FIG. 8, the memory device 100 may include a first semiconductor structure S1 and a second semiconductor structure S2 disposed on the first semiconductor structure. The second semiconductor structure S2 may be bonded onto the first semiconductor structure S1 via a suitable operable connection.

The first semiconductor structure S1 may include a first substrate 410, an isolation layer 501, a gate structure 510, a third insulating layer 505, a bit line contact 506, a bit line BL, a lower contact plug 508, an upper contact plug 509, a landing pad 518, a capacitor 530, a support layer 550, a fourth insulating layer 521, a first contact 581, a liner insulating layer 502, a first insulating layer 300, a second insulating layer 503, a first interlayer insulating layer 430, a first bonding insulating layer 811, a first bonding pad 821, and a bit line connection contact 860.

The second semiconductor structure S2 may include a second substrate 420, a second interlayer insulating layer 440, a second contact 870, a second wiring 592, a second peripheral transistor TR2, source and drain contacts 774 and 775, a second bonding insulating layer 812, and a second bonding pad 822.

In a cell region CR, the first bonding insulating layer 811 and the first bonding pad 821 may be disposed on the first contact 581 and the first interlayer insulating layer 430. The second bonding insulating layer 812 and the second bonding pad 822 may be disposed on the first bonding insulating layer 811 and the first bonding pad 821, respectively. The second bonding pad 822 may overlap with the first bonding pad 821. The second bonding pad 822 may exactly overlap with the first bonding pad 821 in the stacking direction of the first and second semiconductor devices S1 and S2. The second bonding pad 822 may be bonded to the upper surface of the first bonding pad 821. The second bonding insulating layer 812 may be bonded to the upper surface of the first bonding insulating layer 811. The second contact 870 is connected to the second bonding pad 822. The first bonding pad 821 and the second bonding pad 822 may include a conductive material such as metal, metal oxide, metal nitride, metal silicide, polysilicon, conductive carbon or a combination thereof.

In the peripheral region PR, the bit line connection contact 860 extends in the vertical direction VD while contacting a bit line BL. The bit line connection contact 860 may be connected to a corresponding first bonding pad 821.

In the peripheral region PR, the second bonding pad 822 is bonded onto the first bonding pad 821. The second contact 870 is connected to the second bonding pad 822.

The second peripheral transistor TR2 may be connected to one bit line BL through the drain contact 775 connected to a drain region 773, the second wiring 592 connected to the drain contact 775, the second contact 870 connected to the second wiring 592, the second bonding pad 822 connected to the second contact 870, the first bonding pad 821, and the bit line connection contact 860.

Referring to FIG. 9, a first semiconductor structure S1 of the memory device 100 may include a first substrate 410, an isolation layer 501, a gate structure 510, a third insulating layer 505, a bit line contact 506, a bit line BL, a lower contact plug 508, an upper contact plug 509, a landing pad 518, a capacitor 530, a support layer 550, a fourth insulating layer 521, a first contact 581, a first wiring 591, a first insulating layer 900, a second insulating layer 903, and a first interlayer insulating layer 430.

In a peripheral region PR, the first substrate 410 includes at least one trench TRE. The first insulating layer 900 and the second insulating layer 903 may be disposed in the trench TRE. In an embodiment, the first insulating layer 900 and the second insulating layer 903 may surround a region where a memory cell array 110 is disposed.

The first insulating layer 900 may be disposed to fill the interior of the trench TRE. The side surface and the bottom surface of the first insulating layer 900 may contact the first substrate 410. The first insulating layer 900 includes hydrogen. The first insulating layer 900 may be a layer that has higher hydrogen supply capacity than other layers. The first insulating layer 900 may include oxide that has a high hydrogen content. In an embodiment, the first insulating layer 900 may include high density plasma (HDP) oxide.

The second insulating layer 903 may be disposed on the first insulating layer 900. The second insulating layer 903 may cover the entire upper surface of the first insulating layer 900. The side surface of the second insulating layer 903 may contact the first substrate 410. In an embodiment, the upper surface of the second insulating layer 903 may form substantially the same plane as the upper surface of the first substrate 410. In an embodiment, the second insulating layer 903 may include silicon nitride.

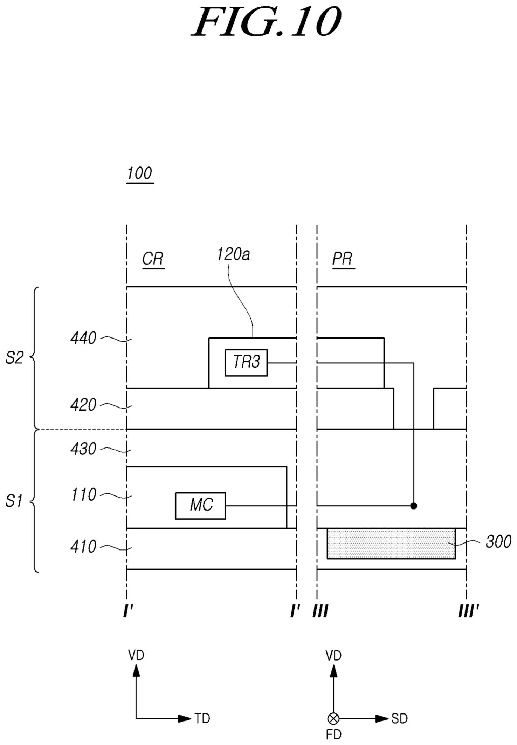

FIG. 10 is a view illustrating still another cross-sectional structure of the memory device according to an embodiment of the present disclosure.

Referring to FIG. 10, the memory device 100 may include a first semiconductor structure S1 and a second semiconductor structure S2 disposed on the first semiconductor structure. The first semiconductor structure S1 may include a first substrate 410, a memory cell array 110, a memory cell MC, a first insulating layer 300 and a first interlayer insulating layer 430. The second semiconductor structure S2 may be disposed on the first semiconductor structure S1. The second semiconductor structure S2 may include a second substrate 420, a first sense amplifier 120a and a second interlayer insulating layer 440.

The first sense amplifier 120a includes a third peripheral transistor TR3. The third peripheral transistor TR3 is one transistor that constitutes the first sense amplifier 120a. In an embodiment, the third peripheral transistor TR3 may be a transistor different from the second peripheral transistor TR2 described above with reference to FIG. 6. In an embodiment, the third peripheral transistor TR3 may be disposed in the cell region CR.

The memory cell MC may be electrically connected to the third peripheral transistor TR3. For example, one memory cell MC may be connected to one bit line BL, and may be electrically connected to the third peripheral transistor TR3 through the one bit line BL.

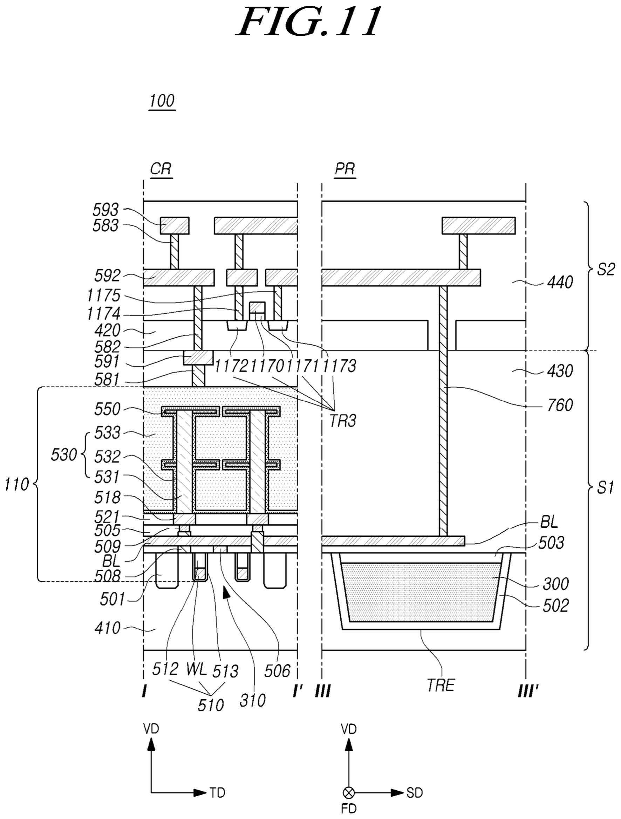

FIG. 11 is a view illustrating the memory device illustrated in FIG. 10.

Referring to FIG. 11, the memory device 100 may include a first semiconductor structure S1, a second semiconductor structure S2, and a bit line connection contact 760.

The first semiconductor structure S1 may include a first substrate 410, an isolation layer 501, a gate structure 510, a third insulating layer 505, a bit line contact 506, a bit line BL, a lower contact plug 508, an upper contact plug 509, a landing pad 518, a capacitor 530, a support layer 550, a fourth insulating layer 521, a first contact 581, a first wiring 591, a liner insulating layer 502, a first insulating layer 300, a second insulating layer 503, and a first interlayer insulating layer 430.

The second semiconductor structure S2 may be disposed on the first semiconductor structure S1. The second semiconductor structure S2 may include a second substrate 420, a second interlayer insulating layer 440, a second contact 582, a third contact 583, a second wiring 592, a third wiring 593, a third peripheral transistor TR3, and source and drain contacts 1174 and 1175.

The third peripheral transistor TR3 may be disposed on the second substrate 420. The third peripheral transistor TR3 includes a gate electrode 1170, a gate insulating layer 1171, a source region 1172 and a drain region 1173. The third peripheral transistor TR3 is a transistor that is included in the first sense amplifier 120a illustrated in FIG. 10. In an embodiment, the third peripheral transistor TR3 may be disposed in a cell region CR. In an embodiment, the third peripheral transistor TR3 may overlap a memory cell array 110.

The source contact 1174 is connected to the source region 1172 and the second wiring 592. The drain contact 1175 is connected to the drain region 1173 and the second wiring 592.

The third peripheral transistor TR3 may be connected to one bit line BL through the drain contact 1175 connected to the drain region 1173, the second wiring 592 connected to the drain contact 1175 and the bit line connection contact 760 connected to the second wiring 592.

Referring again to FIG. 5 and FIG. 7, the memory device 100 may include the first semiconductor structure S1 and the second semiconductor structure S2 that is bonded onto the first semiconductor structure S1. The first semiconductor structure S1 includes the first substrate 410 and the first insulating layer 300. The second semiconductor structure S2 may include the second substrate 420, the first peripheral transistor TR1, and the second peripheral transistor TR2. The first insulating layer 300 may be disposed in the first substrate 410 in the peripheral region PR. The first insulating layer 300 may include high density plasma oxide. The first peripheral transistor TR1 and the second peripheral transistor TR2 may be disposed on the second substrate 420. The first peripheral transistor TR1 is a transistor that constitutes the first sub word line driver 210a. The second peripheral transistor TR2 is a transistor that constitutes the first sense amplifier 120a.

According to an embodiment of the present disclosure, when the first sense amplifier 120a and the first sub word line driver 210a may be disposed on the second substrate 420 of the second semiconductor structure S2, the first insulating layer 300 may be disposed in the first substrate 410 of the first semiconductor structure S1.

In the manufacturing process of a memory device, lattice defects such as silicon dangling bonds may occur in the first substrate 410 as the first substrate 410 is damaged. Because silicon dangling bonds may act as traps that impede the movement of carriers, it is necessary to remove the silicon dangling bonds, and a passivation process may be performed for this purpose. The passivation process is a process that may supply hydrogen into a substrate, and through the passivation process, hydrogen (H) may penetrate into the first substrate 410 to form a Si-H bond structure, thereby reducing silicon dangling bonds. Therefore, in order for effective passivation, it is important for hydrogen to penetrate well into the first substrate 410.

When the first insulating layer 300 with a high hydrogen content is located on the capacitor 530, in order for hydrogen included in the first insulating layer 300 to penetrate into the first substrate 410, hydrogen should pass through many layers existing between the first substrate 410 and the first insulating layer 300. At least some of the layers existing between the first substrate 410 and the first insulating layer 300 absorb hydrogen, and thus, the efficiency of hydrogen supply into the first substrate 410 may decrease. In addition, because hydrogen moves through the capacitor 530, a problem of degradation of the capacitor 530 may occur.

On the other hand, when the first insulating layer 300 is disposed in the first substrate 410, hydrogen included in the first insulating layer 300 may directly penetrate into the first substrate 410 without passing through other layers, so the hydrogen supply capacity may be improved. Therefore, the degradation of memory cells due to silicon dangling bonds may be reduced. Moreover, because the first insulating layer 300 is disposed in the first substrate 410, hydrogen might not pass through the capacitor 530. Therefore, it is possible to prevent degradation that may occur as hydrogen passes through the capacitor 530.

In an embodiment of the present disclosure, a method for manufacturing a memory device including a first semiconductor structure including a memory cell array and a second semiconductor structure including peripheral transistors may include forming a trench in a peripheral region of a first substrate including a cell region and the peripheral region around the cell region, forming a first insulating layer including high density plasma oxide in the trench, forming the memory cell array in the cell region of the first substrate, and forming the peripheral transistors on the memory cell array to be connected to the memory cell array.

In an embodiment of the present disclosure, a method for manufacturing a memory device may include forming, after forming the first insulating layer, a second insulating layer on the first insulation layer.

In an embodiment of the present disclosure, the second semiconductor structure further includes a second substrate, and wherein the peripheral transistors are formed on the second substrate.

In an embodiment of the present disclosure, a method for manufacturing a memory device may include bonding the second semiconductor structure onto the first semiconductor structure.

While detailed embodiments are disclosed in the present disclosure, those skilled in the art will understand that various modifications, additions, and substitutions related to these embodiments are possible without departing from the scope and technical concepts of the present disclosure. Therefore, the scope of the present disclosure should not be limited to the foregoing embodiments. All changes within the meaning and range of equivalency of the claims are included within their scope. Furthermore, the embodiments may be combined to form additional embodiments.

## Claims

1. A memory device comprising:
a first substrate including a cell region and a peripheral region disposed around the cell region;
a memory cell array disposed in the cell region of the first substrate;
a second substrate disposed on the memory cell array;
peripheral transistors disposed on the second substrate, the peripheral transistors being connected to the memory cell array;
a first insulating layer disposed in a trench that is located in the peripheral region of the first substrate, and including high density plasma oxide; and
a second insulating layer on the first insulating layer.

2. The memory device according to claim 1, wherein the second insulating layer covers the upper surface of the first insulating layer.

3. The memory device according to claim 1, wherein the upper surface of the second insulating layer forms substantially the same plane as the upper surface of the first substrate.

4. The memory device according to claim 1, wherein the second insulating layer includes silicon nitride.

5. The memory device according to claim 1, wherein at least one of the peripheral transistors overlaps with the cell region.

6. The memory device according to claim 1, wherein the peripheral transistors configure a sub word line driver or a sense amplifier.

7. The memory device according to claim 6, further comprising:
a bit line; and
a bit line connection contact contacting the upper surface of the bit line, and extending in a direction perpendicular to the upper surface of the bit line to penetrate the second substrate,
wherein the peripheral transistors configure the sense amplifier and are electrically connected to the bit line through the bit line connection contact.

8. The memory device according to claim 7, wherein the bit line connection contact overlaps with the first insulating layer.

9. The memory device according to claim 6, further comprising:
a word line; and
a word line connection contact contacting the upper surface of the word line, and extending in a direction perpendicular to the upper surface of the word line to penetrate the second substrate,
wherein the peripheral transistors configure the sub word line driver and are electrically connected to the word line through the word line connection contact.

10. A memory device comprising:
a first substrate;
a memory cell array disposed on the first substrate;
a first insulating layer disposed in a trench located in the first substrate, surrounding a region where the memory cell array is disposed, and including high density plasma oxide; and
a second insulating layer covering the upper surface of the first insulating layer.

11. The memory device according to claim 10, wherein the upper surface of the second insulating layer forms substantially the same plane as the upper surface of the first substrate.

12. The memory device according to claim 10, wherein the second insulating layer includes silicon nitride.

13. The memory device according to claim 10, further comprising:
peripheral transistors disposed on the memory cell array, and connected to the memory cell array.

14. The memory device according to claim 13, wherein the peripheral transistors configure a sub word line driver or a sense amplifier.

15. The memory device according to claim 13, wherein at least one of the peripheral transistors overlaps with the region where the memory cell array is disposed.

16. A memory device including a first semiconductor structure and a second semiconductor structure bonded onto the first semiconductor structure,
wherein the first semiconductor structure comprises:
a first substrate including a cell region and a peripheral region around the cell region;
a memory cell array disposed in the cell region of the first substrate;
a first insulating layer disposed in the peripheral region of the first substrate; and
a second insulating layer covering the upper surface of the first insulating layer,
wherein the second semiconductor structure comprises:
a second substrate; and
peripheral transistors disposed on the second substrate, and connected to the memory cell array, and
wherein at least one of the peripheral transistors overlaps with the cell region.

17. The memory device according to claim 16, wherein at least another one of the peripheral transistors overlaps with the peripheral region on the second substrate.

18. The memory device according to claim 16, wherein the first insulating layer includes high density plasma oxide.
